(19) Europäisches Patentamt European Patent Office Office européen des brevets

(11) **EP 2 126 986 B1**

(12) **EUROPEAN PATENT SPECIFICATION**

(45) Date of publication and mention of the grant of the patent:
**18.09.2019 Bulletin 2019/38**

(21) Application number: **07861099.5**

(22) Date of filing: **22.12.2007**

(51) Int Cl.:
*B82Y 10/00* (2011.01)　　*G02B 6/10* (2006.01)
*H01L 29/06* (2006.01)　　*H01L 33/00* (2010.01)
*H01L 33/08* (2010.01)　　*H01L 33/18* (2010.01)
*H01L 33/20* (2010.01)　　*H01L 33/44* (2010.01)
*H01L 33/46* (2010.01)　　*H01L 33/60* (2010.01)
*H01L 33/24* (2010.01)　　*B82Y 30/00* (2011.01)
*B82Y 20/00* (2011.01)

(86) International application number:
**PCT/SE2007/001170**

(87) International publication number:
**WO 2008/079076 (03.07.2008 Gazette 2008/27)**

(54) **LED WITH UPSTANDING NANOWIRE STRUCTURE AND METHOD OF PRODUCING SUCH**

LED MIT AUFRECHTER NANODRAHTSTRUKTUR UND HERSTELLUNGSVERFAHREN DAFÜR

DIODE ÉLECTROLUMINESCENTE AVEC STRUCTURE DE NANOFIL VERTICALE ET PROCÉDÉ DE FABRICATION DE CELLE-CI

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **22.12.2006　SE 0602841**
**12.01.2007　SE 0700102**
**15.06.2007　US 812225**
**26.10.2007　SE 0702404**

(43) Date of publication of application:
**02.12.2009　Bulletin 2009/49**

(73) Proprietor: **QuNano AB**
**223 70 Lund (SE)**

(72) Inventors:
• **SAMUELSON, Lars**
**S-217 74 Malmö (SE)**
• **PEDERSEN, Bo**
**2770 Kastrup (DK)**
• **OHLSSON, Jonas**
**S-212 13 Malmö (SE)**

(74) Representative: **Neij & Lindberg AB**
**Pedellgatan 11**
**224 60 Lund (SE)**

(56) References cited:
EP-A2- 0 544 408　　WO-A1-2004/010552
WO-A2-2006/130359　　WO-A2-2008/048704
US-A1- 2004 252 737　　US-A1- 2005 161 662
US-A1- 2005 224 790　　US-A1- 2006 189 018
US-A1- 2006 280 414　　US-B1- 6 455 340

• **FANG QIAN ET AL: "Core/Multishell Nanowire Heterostructures as Multicolor, High-Efficiency Light-Emitting Diodes", NANO LETTERS, vol. 5, no. 11, 1 November 2005 (2005-11-01), pages 2287-2291, XP55034809, ISSN: 1530-6984, DOI: 10.1021/nl051689e**
• **KEIICHI HARAGUCHI ET AL: "GAAS P-N JUNCTION FORMED IN QUANTUM WIRE CRYSTALS", APPLIED PHYSICS LETTERS, AIP, AMERICAN INSTITUTE OF PHYSICS, MELVILLE, NY, US, vol. 60, no. 6, 10 February 1992 (1992-02-10), pages 745-747, XP000298853, ISSN: 0003-6951, DOI: 10.1063/1.106556**

## Description

## Technical field

The present invention relates to light emitting diodes, LEDs. In particular the invention relates to a LED comprising a nanowire.

## Background

The today dominating type of light emitting diodes (LEDs) are built on planar technology. The PN-junction is constructed as a plurality of layers on a substrate giving a device with an essentially horizontal orientation. The light-producing re-combination takes place in a subset of these layers. As the semiconductor layers have refractive indexes that are substantially higher than the refractive index of the air, a substantial portion of generated light will be reflected in the layers and not contribute to the effective luminescence of the device. In fact the layers will act as a waveguide in the horizontal plane of the LED. Measures have been suggested to mitigate the effects of the light of LED being trapped in the device and to efficiently extract the light out of the semiconductor layers. Such measures include modifying the surface in order to provide portions with varying angles to the horizontal plane. A similar approach is suggested in EP1369935, wherein nanosized particles are provided in the LED device to scatter light or alternatively absorb light and generate light of a different wavelength. In addition the planar technology imposes constrains in terms of miniaturization and choices of suitable materials, which will be further described below.

The development of nanoscale technology and in particular the ability to produce nanowires has opened up possibilities of designing structures and combining materials in ways not possible in planar technology. One basis for this development is that the ID properties of a nanowire makes it possible to overcome the requirement of lattice matching between different materials in a device made with planar technology. It has been shown and utilized that nanowires of for example InP can be grown on InAs or Si without defects. In US 20040075464 by Samuelson et al a plurality of devices based on nanowire structures are disclosed, for example nanowire LEDs. These LEDs have an internal heterostructure giving quantum confinement effects.

US20030168964 teaches an assembly of a plurality of nanowires acting as LEDs mounted in groups between a conductive transparent substrates at the lower end of the nanowires and a transparent cover substrate at the top end, each individual nanowire having a structure of P-type, N-type and light emitting layer. The nanowires are said to be arranged to emit light through the conductive transparent substrate.

Other nanowire LED have previously been reported. Hiruma et al. fabricated vertical GaAs nanowire pn LEDs. The nanowires were embedded in an SOG and covered with an Au/Ge/Ni top contact described in "GaAs p-n junction formed in quantum crystals" by Haraguchi et al., Appl. Phys. Lett. 60 (6) 1992. These devices showed room temperature electro luminescence. GaN based nanowire LEDs have also been fabricated as described in " Core/ Multishell Nanowire Heterostructure as Multicolor, High-Efficiency Light-Emitting Diodes" by Quian et al., Nanoletters.

US2006280414 discloses a device comprising a single photon generator and a waveguide, wherein a single photon generated by the single photon generator is coupled to the waveguide.

US2005224790 discloses a nanowire light emitting device and a method of fabricating the. The nanowire light emitting device includes a first conductive layer on a substrate, a plurality of nanowires on the first conductive layer, each nanowire having a p-type doped portion and an n-type doped portion on both ends, a light emitting layer between the p-type doped portion and n-type doped portion, and a second conductive layer formed on the nanowires. The doped portions are formed by adsorbing molecules around a circumference thereof.

## Summary of the invention

It has in the art been shown that nanowires can be utilised for constructing LEDs. To provide efficient devices suitable for industrial production methods further improvements are needed.

The object of the present invention is to provide a nanostructured LED and a method of producing such overcoming the drawbacks of the prior art devices and methods. This is achieved by the device as defined in claim 1 and the method as defined in claim 6.

The nanostructured LED according to the invention comprises a substrate and at an upstanding nanowire protruding from the substrate. A pn-junction giving an active region to produce light is present within the structure during use. The nanowire, a part of the nanowire, or a structure in connection with the nanowire, forms a waveguide directing at least a portion of the light produced in the active region in a direction given by the nanowire.

The nanostructured LED further comprises a volume element epitaxially connected to the nanowire. The volume element provides a high doping degree for the formation of the active region, typically within or close to the nanowire, without requiring the nanowire itself to be doped.

The waveguide has a first effective refractive index, $n_W$, and the material surrounding at least a portion of the waveguide has a second effective refractive index, $n_C$, and by assuring that the first refractive index is larger than the second refractive index, $n_W > n_C$, good waveguiding properties are provided to the waveguide. The waveguiding properties may be further improved by introducing optically active cladding layers on the waveguide.

Thanks to the present invention it is possible to make use of a very large portion of the produced light and whereby effective LEDs can be provided. This is at least partly achieved by the nanowire being used as a waveguide, directing the produced light out of the surface. The nanostructured LED according to the invention is well suited for mass production, and the method described scaleable to industrial use.

The use of the nanowire as a waveguide offers a possibility to direct light in well defined directions. By using concepts from the area of fiber optics light beams can be focused, or dispersed, depending on the intended use.

The nanowire technology offers possibilities in choices of materials and material combinations not possible in conventional bulk layer techniques. This is utilised in the nanostructured LED according to the invention to provide LEDs producing light in wavelength regions not accessible by conventional technique, for example violet and UV.

The design according to the invention allows for inclusions of heterostructures as well as areas of different doping within the nanowire, facilitating optimization of electrical and/or optical properties.

Embodiments of the invention are defined in the dependent claims. Other objects, advantages and novel features of the invention will become apparent from the following detailed description of the invention when considered in conjunction with the accompanying drawings and claims.

**Brief Description of the Drawings**

Preferred embodiments of the invention will now be described with reference to the accompanying drawings, wherein:

Fig. 1 a illustrates schematically an example of a nanostructured LED, Fig. 1b illustrates schematically an embodiment of a nanostructured LED according to the present invention.

Fig. 2 illustrates schematically the waveguiding properties of the nanowire of the nanostructured LED;

Fig. 3a-b illustrates schematically the use of an reflective layer in combination with a nanostructured LED;

Fig. 4. illustrates schematically an embodiment of a nanostructured LED;

Fig. 5 illustrates schematically an embodiment of a nanostructured LED

Fig. 6 illustrates schematically an embodiment of a nanostructured LED;

Fig. 7 illustrates schematically an embodiment of a nanostructured LED;

Fig. 8 illustrates schematically an embodiment of a nanostructured LED;

FIG. 9 illustrates schematically an embodiment of a nanostructured LED;

FIG. 10 illustrates schematically an assembly of a plurality of nanostructured LEDs;

FIG. 11 illustrates schematically an assembly of a plurality of a nanostructured LEDs in combination with a reflective plane;

FIG. 12 illustrates schematically a nanostructured LED comprising nanowires on a planar light emitting structure;

FIG. 13 illustrates the basic production steps in an exemplary method.

Fig. 14 schematically illustrates a LED nanostructure;

Fig. 15a is a SEM-image of a nanostructure LED according to Fig. 14, and 15b is is an image of an active LED nanostructure;

Fig. 16 is a SEM image of nanowire structures of the invention after the first MOVPE step;

Figs. 17a-c are photoluminescence graphs of nanowires and LED nanostructure according to Fig. 14 and Fig. 16;

Figs. 18 shows a) Power dependence of Electroluminescence of GaAs LEDs grown on GaP and Si, b) EL spectra at 80 mA from GaP and Si based LED nanostructures;

Figs. 19a-b shows SEM images of the sample grown with a NH3 flow rate of 3.0 sccm;

Figs 20a-b shows SEM images of the sample grown with a NH3 flow rate of 1.0 sccm;

Figs 21a-b shows SEM images of the sample grown with a NH3 flow rate of 0.5 sccm, and

Fig. 22 shows SEM images of the sample grown with a NH3 flow rate of 0.2 sccm.

**Detailed description**

An nanostructured light emitting diode according to the invention comprises an upstanding nanowire. Suitable methods for growing nanowires on semiconductor substrates are described in US 2003010244. Methods of providing epitaxally grown nanowires with heterostructures are to be found in US 20040075464.

For the purpose of this application an upstanding nanowire should be interpreted as a nanowire protruding from the substrate in some angle, the upstanding nanowire for example grown epitaxially from the substrate. The angle with the substrate will typically be a result of the materials in the substrate and the nanowire, the surface of the substrate and growth conditions. By controlling these parameters it is possible to produce nanowires pointing in only one direction, for example vertical, or in a limited set of directions. For example nanowires and substrates of zinc-blende and diamond semiconductors composed of elements from columns III, V and IV of the periodic table, such nanowires can be grown in the [111] directions and then be grown in the normal direction to any {111} substrate surface. Other directions given as the angle between normal to the surface and the axial direction of the nanowire include 70,53° {111}, 54,73° {100}, and 35,27° and 90°, both to {110}. Thus the nanowires define one, or a limited set, of directions.

According to the invention the nanowire of the nanostructured LED, a part of the nanowire or structure formed from the nanowire is used as a waveguide directing at least a portion of the light produced by the nanostructured LED in a direction given by the upstanding nanowire. The ideal waveguiding nanowire LED structure includes a high refractive index core with one or more surrounding cladding with refractive indexes less than that of the core. The structure is either circular symmetrical or close to being circular symmetrical. Light generation waveguiding in circular symmetrical structures are well know for fiber-optic applications and many parallels can be made to the area of rare-earth-doped fiber amplifiers and lasers. However, one difference is that fiber amplifier are optically pumped while the described nanowire LED structure can be seen as electrically pumped. One well know figure of merit is the so called Numerical Aperture, $NA$: $NA = \sqrt{n_1^2 - n_2^2}$ , wherein $n_1$ and $n_2$ are the refractive indexes of the core and cladding, respectively. The NA determined the angle of light captured by the waveguide. For light generated inside the core of the waveguide the angle of capture, $\varphi$, can be determined as $n_1 \cdot \cos(\varphi) = n_2$. The NA and angle of captured light is an important parameter in the optimization of a new LED structure.

Typical values for III-V semiconductor core material is refractive indexes in the range from 2.5 to 3.5. When combined with glass type of cladding material such as $SiO_2$ or SiN having refractive indexes ranging from 1.4 to 2.0, the angle of capture can be as high as 65 degrees. An angle of capture of 65 degrees yield that up to 75% of the light generated can be captured and guided by the structure (both directions).

One consideration in the optimization of light extraction is to made the $NA$ vary along the nanowire structure to optimize light extraction from the structure. In general, it is ideal to have the $NA$ be highest when the light generation takes place furthest away from the exit location. This will maximize the light captured and guided toward the exit. In contrast, closer to the exit end of the structure, the NA can be made smaller since light generated will radiate in random directions and most of the radiate light will hit the top and side of the top part of the structure and exit. Having a lower $NA$ in the top part of the structure also minimizes the light captures and guide back down through the structure which may not be ideal unless a reflector is inserted in the bottom of the structure. A low $NA$ can be obtained by surrounding the III-V nanowire core with another III-V cladding of different composition with slightly less refractive index.

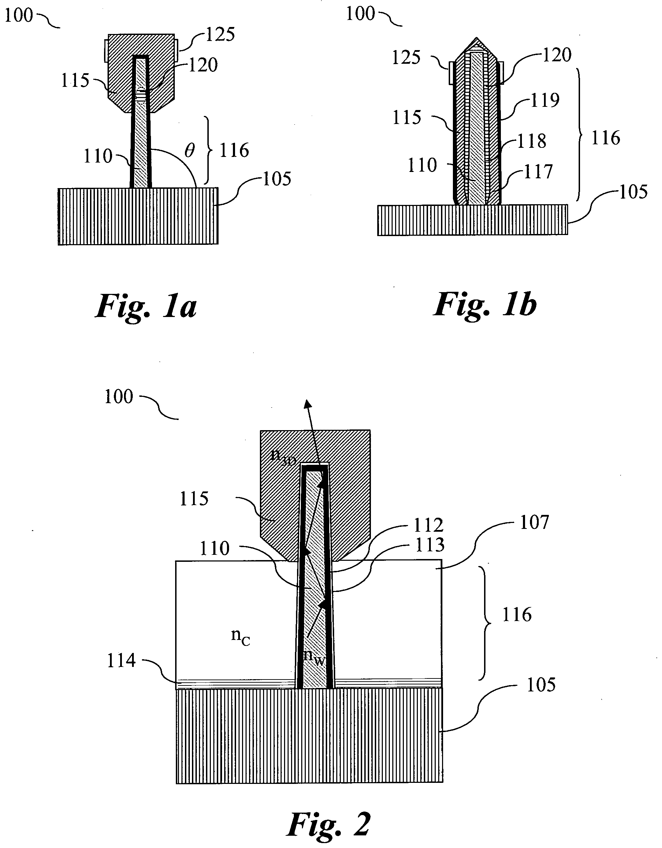

A nanostructured LED 100 is schematically illustrated in FIG. 1a and comprises a substrate 105 and a nanowire 110 epitaxially grown from the substrate in an defined angle $\theta$. A portion of the nanowire is enclosed by a volume element 115. The volume element 115 is preferably epitaxially connected to the nanowire 110. A portion the nanowire of the nanowire 110 are arranged to act as a waveguiding portion directing at least a portion of the produced light in a general direction given by the elongated direction of the nanowire, and will be referred to as a waveguide 116 A pn-junction necessary for the diode functionality is formed by combination of the nanowire 110 and the volume element 115. The volume element provides a high degree of doping, and hence the pn-junction can be formed without a direct doping of the nanowire 110, or at least without varying the direct doping of the nanowire 110. This is advantageous since doping of the ID structure can be technologically challenging and costly to implement in large scale production. The function of the volume element 115 and the interplay between the nanowire 110 and the volume element 115 will be further discussed below. A contact 125 is provided on the volume element 115, for example on top, or in a wrapping configuration on the circumferential outer surface (depicted). The substrate 105 and part of the upstanding structure may be covered by a cover layer 107, for example as a thin film as illustrated or as material filling the space surrounding the nanostructured LED.

The nanowire 110 typically has a diameter in the order of 50 nm to 500 nm, and the volume element a diameter in the order of 500 nm to 1000 nm, i.e. a thickness in the order of 200 nm for the part of the volume element enclosing the nanowire. The length of the waveguide portion 116 of the nanowire is typically and preferably in the order of 1 to 10 $\mu$m. The length of the volume element is typically and preferably in the order of 1 to 5 $\mu$m. The dimensions of the volume element should be such that the properties as regards to for example receptivity to doping those generally associated and expected from a bulk material. A volume element of for example InGaP:Si with a thicknesses above 150 nm has been shown to show acceptable receptivity to doping. The dimensions, both in actual numbers and that of the parts relative to each other can be varied in order to optimize certain criteria and to accommodate for different combinations of materials.

The pn-junction results in an active region 120 arranged in the nanowire, or in the vicinity of the, wherein the light is produced. It should be noted that the position of active region 120 in FIG. 1a is a non-limiting example. Illustrated in FIG. 2 are the waveguide properties of the waveguide portion 116. The materials of the different members of the nanostructured LED are chosen so that the nanowire will have good waveguiding properties vis-à-vis the surrounding materials, i.e. the refractive index of the material in the nanowire 110 should be larger than the refractive indices of the surrounding materials. If the nanowire 110 has a first refracting index, $n_W$, the material surrounding the nanowire in wave guide portion 116, typically the cover layer 107, a second refractive index, $n_C$, and the a volume element a third refractive $n_{VE}$, $n_W >$

$n_C$ and $n_W > n_{VE}$. Typical values for the nanostructured LED are $n_W \approx 3$, $n_C \approx 1.5$ and $n_{VE} \approx 3$.

The nanowire 110 may be provided with one or more cladding layers. A first cladding layer 112, may be introduced to improve the surface properties of the nanowire, fore example if a GaAs nanowire is utilized it has been shown that the properties are improved by adding a cladding layer 112 of GaInP. Further cladding layers, for example an optical cladding layer 113 may be introduced specifically to improve the waveguiding properties of the nanowire 110, in manners similar to what is well established in the area of fiber optics. The optical cladding layer 113 typically has a refractive index in between the refractive index of the nanowire and the surrounding material. Alternatively the cladding layer 113 has a graded refractive index, which has been shown to improve light transmission in certain cases. If an optical cladding layer 113 is utilised the refractive index of the nanowire, $n_W$, should define an effective refractive index for both the nanowire and the cladding layers.

The ability to grow nanowires with well defined diameters, as described in the above cited references and exemplified below, is in one embodiment of the invention utilised to optimise the waveguiding properties of the nanowire 110, or at least the waveguide 116, with regards to the wavelength of the light produced by the nanostructured LED 100. As is well known the re-combination process that is the basis for the light production of a LED, produces light in a narrow wavelength region, dependent on the material properties. In the embodiment the diameter of the nanowire 110 is chosen so as to have a favourable correspondence to the wavelength of the produced light. Preferably the dimensions of the nanowire 110 are such that an uniform optical cavity, optimised for the specific wavelength of the produced light, is provided along the nanowire. The core nanowire must be sufficiently wide to capture the light. A rule of thumb would be that diameter must be larger than $\lambda/2n_\omega$, wherein $\lambda$ is the wavelength of the produced light and $n_w$ is the refractive index of the nanowire 110.

For a nanostructured LED arranged to produce light in the visible region the diameter of the waveguide of the nanowire should preferably be larger than 80 nm in order for the nanowire to be an effective waveguide. In the infra-red and near infra-red a diameter above 110 nm would be sufficient. An approximate preferred upper limit for the diameter of the nanowire is given by the growth constrains, and is in the order of 500 nm. The length of the nanowire 110 is typically and preferably in the order of 1-10 $\mu$m, providing enough volume for the active region 120, and at the same time not unnecessarily long to cause internal absorption.

FIG. 1b illustrates an embodiment of the invention wherein the volume element 115 comprises a plurality of layers 117, 118 in a shell-like structure. Tbe plurality of layers may include a doping layer 117 which provides the p or n region and a well layer 118 which will comprise the active region 120 under operation. Alternatively the well can be made out of a plurality of sub-layers. Hence, in this embodiment the active region 120 will primarily be radially outside of the nanowire 110. According to this embodiment the waveguide 116 can be formed by the shell-like structure of layers 117 and 118 and optional further cladding layer or layers 119 with properties to enhance the waveguiding as discussed above. The nanowire 110 may typically be part of the waveguide 116. Alternatively the waveguiding is as much as possible confined to the shell-like structure.

In the following different examples are illustrated primarily with reference to FIG. la. As should be apparent for the skilled person the different examples should with only minor adjustment be relevant also for the design with a shell-like structure described with references to FIG. 1b.

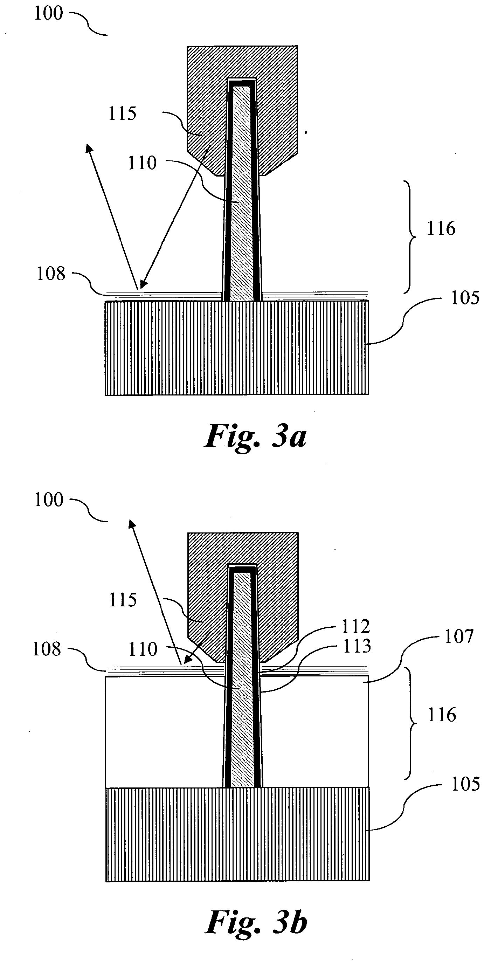

A reflective layer 108 is in one example, illustrated in FIG. 3a-b provided on the substrate 105 (FIG. 3a), or alternatively on the cover layer 107 (FIG. 3b), if such is utilised. The purpose of the reflective layer is to reflect light that is emitted from the nanostructured LED in downward directions. The reflective layer 108 is preferably provided in the form of a multilayered structure comprising repeated layers of AlGaS/GaAs or GaN/Al-GaN for example, or as a metal film.

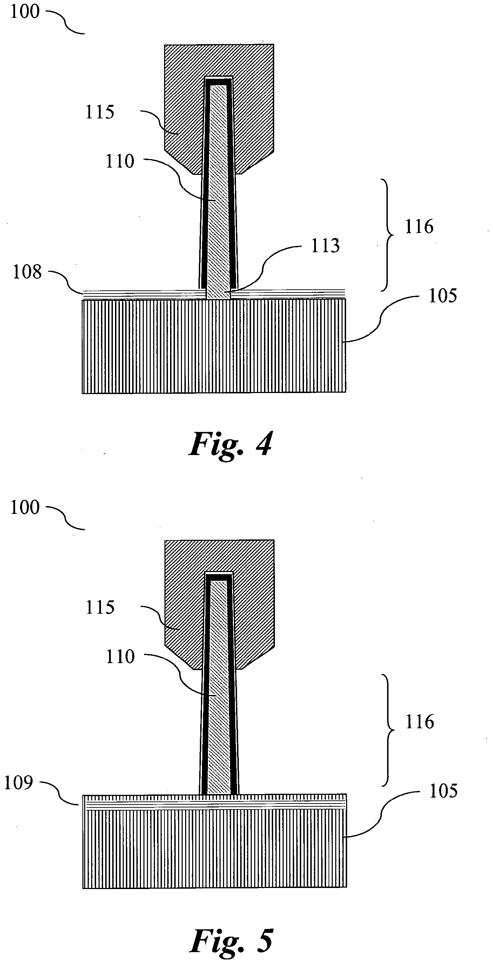

According to one example, illustrated in FIG. 4, the reflective layer 108 is arranged to continue under a portion of the waveguide 116, or the nanowire/waveguide/cladding combination, hence a stem 113 adjacent to the substrate is formed, the stem 113 having a smaller diameter than the nanowire/cladding above. A method of producing such will be described below. If the diameter of stem 113 is sufficiently smaller than the wavelength of the light a large fraction of the directed light mode will extend outside the waveguide, enabling efficient reflection by the reflective layer 108 layer surrounding the narrow part of the waveguide. The reflective layer 108 can be perpendicular to the nanostructured LED or alternatively is designed so that a large amount of the light hitting the reflective layer 108 will be reflected in the upward direction. By fabricating the layer and the waveguide in an configuration with another angle than 90° the light can be directed at a different direction than the waveguide. A special case of such is when the nanowires are grown in an angle to the substrate separate from 90°. If the waveguide 116, or nanowire+cladding, has a first effective refracting index, $n_w$, and the reflective layer has a second effective refracting index, $n_s$, and $n_W > n_C$. the angle between nanowire and reflective layer can be chosen to achieve total internal reflection.

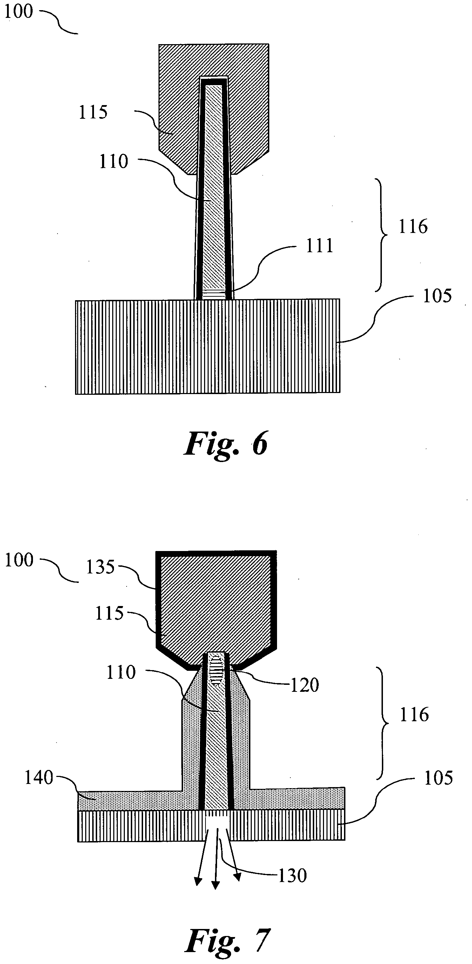

An alternative approach to get a reflection in the lower end of the waveguide 116 is to arrange a reflective layer 109 in the substrate underneath the nanowire, as illustrated in FIG. 5. The reflective layer may for example be a multilayer structure as above which in the art is known to produce highly reflective surfaces. Yet another alternative is to introduce reflective means 111 within the waveguide 116, as illustrated in FIG. 6. Such reflective means can be a multilayered structure provided during the growth process of the nanowire, the multilayered structure comprising repeated layers of for example $SiN_x/SiO_x$ (dielectric) or GaAs/AlGaAs (semiconductor). The reflective means are preferably positioned below the active region, for example close to the substrate, as depicted, if the nanostructured LED is primarily emitting light from the top of the nanowires. Alternatively if a flip-chip configuration is used and light is primarily from the lower end of the waveguide 116, the reflective means 111 should preferably be placed above the active region.

In a further example, illustrated in FIG. 7, a major part of the produced light is directed by the waveguide 116 of the nanowire 110 or waveguide 116 in a downward direction through the substrate 105. The light can be directed through the entire thickness of the substrate, or alternatively the substrate is provided with a cut out 130 beneath the base of the nanowire 110 in order to reduce the thickness of the substrate and thereby reduce the scattering or absorption of light in the substrate. The substrate is preferably made of transparent material. Alternatively the nanostructered LED can be removed from the substrate. In this case the nanowire can at its lower end by contacted by a wrap contact. A portion, or preferably all of the outer surface of the volume element 115 may be covered by a reflective layer 135 which increases the radiation of the produced light through the waveguide 116. The reflective layer, for example formed of a metal, may additionally serve as a contact. Part of the nanowire 110 and the substrate is optionally covered by a protective layer of $SiO_2$.

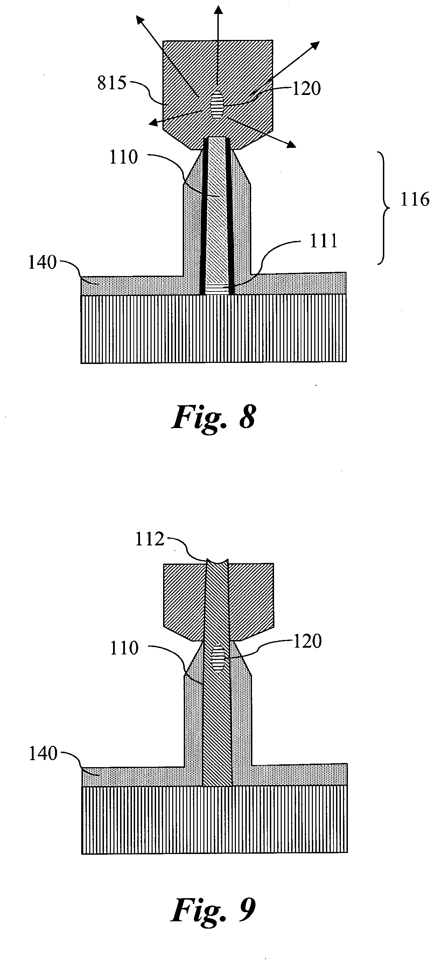

In an example illustrated in FIG. 8 the volume element 815 is arranged to be a dispersive element, giving a light radiation that is essentially evenly distributed over a wide angle. Such device is well suited for illuminating purposes wherein an even illumination is required. The active region 120 may be arranged in the nanowire but alternatively within the volume element, and above the upper end of the nanowire 110 as depicted, or radially outwards of the nanowire and possibly above. The nanowire 110 should preferably at is lower end be provided with some of the reflective means described above, for example reflective means 111 within the nanowire, in order to redirect light upwards. The geometry of the volume element can be designed to further disperse the light. Dispersion is provided at the junction between the nanowire 110 waveguide and the volume and further at the edge formed by the upper boundary of the volume element 115. The height and width of the volume element are chosen so that the edge distribute the angle of the dispersed light further.

The waveguiding properties of the nanowire LED also provides for a collected and directional oriented beam which can be shaped and directionally steered to provide for a desired radiation pattern. This can be done by a combination of shaping the exit interface in a lens-like fashion and by using the variable NA method previously described. In general, if a broader radiation pattern is desired, the NA close to the exit should be altered to smaller values either gradually or abruptly at some distance from the exit surface. If it is desirable to have a narrow radiation pattern, this can be accomplish either by having a focussing concave lens like exit surface or/and maintaining as high an NA as possible in the top part of the nanowire LED close to the exit. The diameter of the core nanowire also plays an important role in shaping radiation pattern. In general the smaller the diameter the wider the radiation pattern, while a large diameter core nanowire would call for a more confined and directional radiation pattern. This - perhaps counter intuitive - effect is well know in optical engineering as the far-field radiation pattern is in fact a Fourier transform of the near-field. As is well know, the Fourier transform of a short or narrow event yields a long or wide event in the Fourier domain. One extreme example is the delta function, which has Fourier transform that is infinitely wide and constant in density. The parallel to optical radiation is that a point light source (delta-function in near field) radiates with constant density in all directions ("infinitely" wide radiation in the far-field). One further example schematically illustrated in FIG. 9, is optimized for providing a collected and directional oriented beam. The nanowire 110 of relatively large diameter, preferably above 150 nm, extends to the upper surface of the volume element 115. The nanowire 110 is provided with a concave lens like exit surface 112 on the upper end.

The previous depicted cylindrical volume element 115, which is achievable with the referred methods of growing nanowires, should be seen as an exemplary shape. Other geometries that are plausible include, but is not limited to a cylindrical bulb with a dome-shaped top, a spherical/ellipsoidal, and pyramidal.

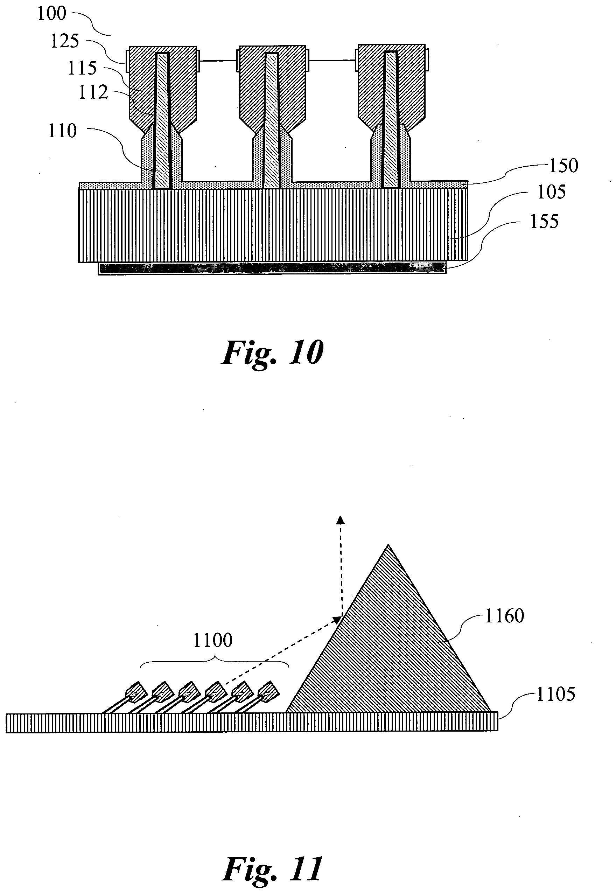

In typical implementations a large plurality of nanostructured LEDs are provided in one device. A portion of such device is illustrated in FIG. 10. A plurality of nanostructured LEDs 100 have been epitaxilly grown on a Zn-doped GaP substrate 105. The nanowires 110 of the LEDs are of intrinsic GaAs, and provided with a concentric layer of undoped InGaP. The volume elements 115 comprises of Si-doped InGaP. The lower parts of the nanowires and the substrate are covered by a $SiO_2$-layer 150. A back plane contact 155 is provided on the substrate connecting a plurality of LEDs, and each individual LED is provided with a wrap around contact 125 on the volume elements 115. The wrap around contacts 125 are connected for a group-wise addressing of the LEDs.

In one example the inherent property that nanowires grow in a limited set of preferred directions, as discussed above, is utilized. A plurality of nanostructured LEDs 1100 are provided on a substrate 1105, as illustrated in FIG. 11. All LEDs having the same direction, or one of a limited set of directions. Preferably the LEDs are arranged to produce fairly directed light beams. Adjacent to the group of LEDs reflective means 1250 is provided, with an angle to the substrate corresponding to the direction of the LEDs so that the light emitted from the LEDs are reflected by the reflective means 1160 in an desired direction. The path of light is schematically indicated with dashed arrows. If the LEDs have a plurality of directions, for example corresponding to the four [111] directions, a corresponding plurality of reflecting means can be provided, preferably directing all light into the same direction, for example perpendicular to the substrate.

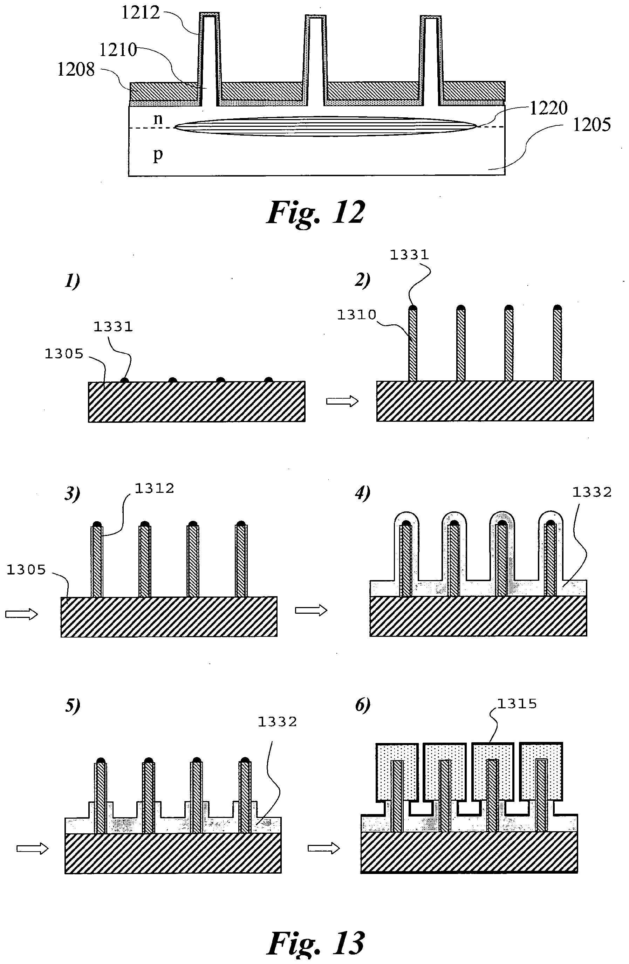

Nanowires acting as waveguides can be utilised to improve the performance of conventional planar LEDs. In the example depicted in FIG. 12 a plurality of nanowires 1210 are arranged on the surface of a planar LED. Light is produced in the active layer 1260 of the planar LED, for example of GaAsP. The nanowires 1210 are epitaxially connected on top of the planar LED layers in order to get a good matching of the different parts. The nanowires 1210 may be coated by a cladding layer 1212 protecting the nanowires and/or improving the properties, for example $Si_3N_4$. The surface in between the nanowires 1210 are preferably coated with a reflective layer 1208, for example of Au. At least a part of the light produced in the active region 1220 will enter the nanowires 1210 acting as waveguides, leading the light away from the substrate plane. By the same mechanism as described above the nanowires can be arranged to focus the light in a well defined direction or directions.

To form the pn-junction necessary for light production at least part of the nanostructure need to be doped. As indicated above the volume element is provided partly to solve general difficulties associated with doping of nanoelements, and to facilitate good electrical contacting properties. It is important to decrease access resistances in order to increase device efficiency. The nanowire in itself is not optimal from this perspective as the elongated nature and low area of the nanowire cross-section will build device resistance.

The main tools of fabricating low resistance contacts, a task complicated by the intrinsically low contact-surfaces given by the nanowire geometry, are high doping and low band gap adjustment on the semiconductor side of the contact, but as mentioned, the doping of nanoelements is challenged by several factors. However, certain other parts of a nanowire device are not in need of high doping, or, their doping-level is of less priority and can be balanced against other design parameters. There are also devices where doping of critical parts will decrease device performance. Such examples of contra-productive doping effects are non-emitting impurity levels in an optical region or impurity scattering, decreasing mobility, in a field effect channel.

The volume element 115 according to the invention extends in three dimensions, has a large volume and a large surface, whereby the challenging doping procedures for nanoelements may be avoided, the processing is simplified and more reliable, the access resistance may be decreased, both due to doping and to an increased contact surface, the advantages of using a nanowire as an active component in an LED may fully utilized.

The volume element/nanowire architecture enhances both electrical and optical performance of a LED. The volume element 115 works as a carrier reservoir enabling high carrier injection into the nanowire from a region with well defined doping where low resistance contacts easily can be fabricated, preferably in a wrap around configuration in order to increase contact area and minimize distance between the nanowire and the contact. The low internal resistance and the increased amount of carriers vouch for a high injection of majority carriers into the nanowire already at low forward voltages. High injection of carriers into the nanowire 110 introduces high concentrations of electron hole pairs into the nanowire increasing light emitting recombination. The high concentration of electron-hole pairs, in combination with the active region being extended into a waveguide, directing the light, can enable stimulated emission, increasing the output of the device further.

By using different material compositions in the nanowire 110 and the volume element 115, the nanowire material composition can be chosen to propagate into the volume element 115 in order to decrease the optical disturbance by the connection with the nanowire. Extending the length of the nanowire in the direction of the emitted light will increase re-absorption. To decrease re-absorption the composition of the nanowire is adjusted in the direction of the emitted light in order to raise the band gap as compared to the energy of the emitted light.

A method of fabricating nanostructured LED is to first grow a nanowire, according to the above referred processes. Part of the nanowire is then masked and the volume element is re-grown selectively. The method is illustrated in FIG. 13. The volume element grows both axially and radially, hence, when the nanowire is masked partly, the nanowire becomes enclosed in the volume element. Appropriate masking materials are e.g. silicon nitride, silicon oxide etc.

Considering systems where nanowire growth is locally enhanced by a substance, as VLS grown nanowires, the ability to alter between radial and axial growth by altering growth conditions enables the procedure (nanowire growth, mask formation, and subsequent selective growth) can be repeated to form nanowire/3D-sequences of higher order. For systems where nanowire growth and selective growth are not distinguished by separate growth conditions it may be better to first grow the nanowire along the length and by different selective growth steps grow different types of 3D regions or volume elements.

A fabrication method according to the present invention in order to fabricate a light emitting pn-diode/array with active nanowire region(s) formed of GaAs and InGaP, illustrated in Fig. 13 comprises the steps of:

     1. Defining of local catalyst/catalysts on a p+ GaP substrate 1305 by lithography.

2. Growing GaAs nanowire 1310 from local catalyst 1331. The growth parameters adjusted for catalytic wire growth.

3. Radial growing of thin InGaP concentric layer 1312 around the nanowire (cladding layer).

4. Depositing of $SiO_2$ as mask material 1332,

5. Back etching of mask 1332 to open up the upper parts of the nanowires

6. Selective growing of n+ InGaP volume element 1315. The growth parameters adjusted to give radial growth.

7. (not shown) Forming contacts 1325 on the volume element and to the substrate.

The growth process can be varied in known ways to for example include heterostructures in the nanowires, provide reflective layers etc. The stem 113 utilized in some embodiment can be provided by first growing a thin nanowire (step 2), depositing a reflective layer or a selective growth mask covering the lower part, and radial growing of cladding layer or the nanowire to increase the nanowire thickness.

Depending on the intended use of the nanostructured LED, availability of suitable production processes, costs for materials etc, a wide range of materials can be used for the different parts of the structure. In addition the nanowire based technology allows for defect free combinations of materials that otherwise would be impossible to combine. The III-V semiconductors are of particular interest due to their properties facilitating high speed and low power electronics. Suitable materials for the substrate include, but is not limited to: Si, GaAs, GaP, GaP:Zn, GaAs, InAs, InP, GaN, $Al_2O_3$, SiC, Ge, GaSb, ZnO, InSb, SOI (silicon-on-insulator), CdS, ZnSe, CdTe. Suitable materials for the nanowire 110 and the volume element 115 include, but is not limited to: GaAs (p), InAs, Ge, ZnO, InN, GaInN, GaN AlGaInN, BN, InP, InAsP, GaInP, InGaP:Si, InGaP:Zn, GaInAs, AlInP, GaAlInP, GaAlInAsP, GaInSb, InSb, Si. Possible donor dopants for e.g. GaP are Si, Sn, Te, Se, S, etc, and acceptor dopants for the same material are Zn, Fe, Mg, Be, Cd, etc. It should be noted that the nanowire technology makes it possible to use nitrides such as GaN, InN and AlN, which gives facilitates fabrication of LEDs emitting light in wavelength regions not easily accessible by conventional technique. Other combinations of particular commercial interest include, but is not limited to GaAs,GaInP, GaAlInP, GaP systems. Typical doping levels range from $10^{18}$ to $10^{20}$. A person skilled in the art is though familiar with these and other materials and realizes that other materials and material combinations are possible.

The appropriateness of low resistivity contact materials are dependent on the material to be deposited on, but metal, metal alloys as well as non-metal compounds like Al, Al-Si, $TiSi_2$, TiN, W, $MoSi_2$, PtSi, $CoSi_2$, $WSi_2$, In, AuGa, AuSb, AuGe, PdGe, Ti/Pt/Au, Ti/Al/Ti/Au, Pd/Au, ITO (InSnO), etc. and combinations of e.g. metal and ITO can be used.

Examples of realizations of the nanostructured LED will be given as GaAs nanowires epitaxially grown on GaP and Si substrates. The LED functionality has been established on both kinds of substrates. The structures are evaluated in terms of temperature-dependent photoluminescence, electroluminescence, and radiation pattern.

A LED device according to the realisation comprises arrays of III-V light emitting nanowire diodes, grown and integrated on Si. Each device is built around a GaAs nanowire core, directly grown on either GaP or Si. A portion of each diode acts as the active region in these individual nanosized p-i-n light emitting structures.

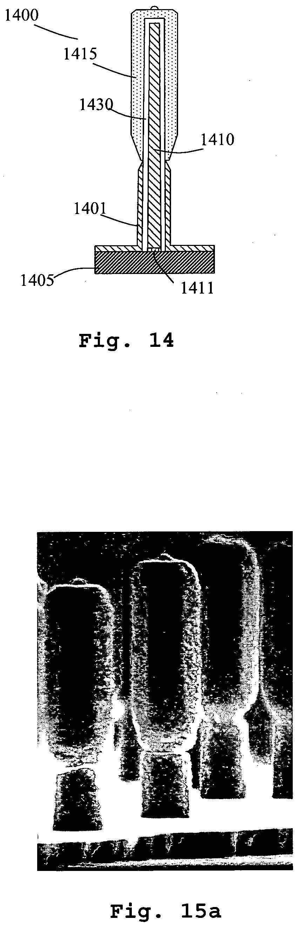

The LED device 1401, shown in Fig. 14, comprises of p-i-n diode structures 1400. The substrate 1405 is an integral part of the device, as it functions as a common p-layer. Each nanostructured LED 1400 structure comprise a nanowire 1410, a cladding 1430 enclosing at least a portion of the nanowire, a cap or bulb 1415 and a top contact. The sequence of p-doped, n-doped and intrinsic semiconductor materials will depend on the substrate material. On GaP the structure is: p-GaP (substrate) 1405, i-GaP 1411/i-GaAs (nanowire) 1410, i-InGaP (cladding) 1430, n-InGaP (bulb) 1415. On Si the structure is: p-Si(substrate) 1405, i-GaP/i-GaAs (nanowire) 1410, i-InGaP (cladding) 1430/n-InGaP (bulb) 1415. The i-GaP 1411 (nanowire) layer in the nanowire base is approximately 60 nm thick in both the devices and serves the dual purposes of a nucleation segment for improved growth quality and electron barrier.

The fabrication process is outlined in the following. THMa metal organic sources and TMIn together with $AsH_3$, $PH_3$, and $Si_2H_6$ as precursor gases were used. Two growth steps were employed. First, 2 $\mu$m long GaAs/GaP nanowires were grown on p-type GaP (111)B (p=~$10^{18}$cm$^{-3}$) and Si (111) (p≈$10^{15}$cm$^{-3}$) substrates by particle assisted growth using randomly deposited, 60nm diameter nm sized Au aerosols with a particle density of 1 / $\mu$m$^2$. The nanowires were enclosed with 40 nm thick radial InGaP cladding layer, nominally lattice matched to GaAs. After this step, samples were unloaded for photoluminescence characterization or subsequent fabrication of the nano LEDs. 80 nm thick $SiO_2$ was deposited onto the samples lined for LED fabrication. The $SiO_2$ was back etched back to only cover the substrate surface and up to approximately 1$\mu$m of the side wall of the nanowire. The samples were then reloaded into the MOVPE reactor and a radial Si-doped InGaP layer was selectively grown on the upper part of the GaAs/InGaP core structure. The LEDs were fully covered with 150-300 nm thick 200x200$\mu$m$^2$ quadratic Ni/Ge/Au contacts, each covering approximately 40000 individual nanostructured LEDs. The p-contact was fabricated on the backside of the substrate with conductive Ag paste. Other means of contacting, for example using transparent contacts are known in the art and easily adopted to the present method and device. A scanning electron microscopy (SEM) image of the structure is shown in FIG. 15a.

One important difference between the Si and the GaP device is the heterostructure sequence in the base of the nanowire, on GaP substrate being p-GaP (substrate)/i-GaP (nanowire)/i-GaAs (nanowire), while on Si substrate being p-Si (substrate)/i-GaP (nanowire)/i-GaAs (nanowire), and both hole injection conditions and internal resistance and should be expected to be appreciably different between the two structures.

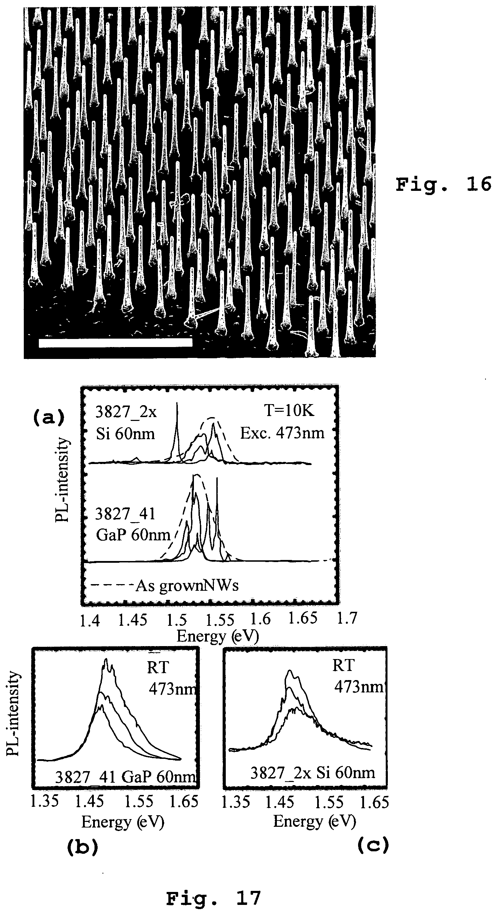

FIG. 16 depicts nanowire structures after the first MOVPE step. Depicted are GaAs nanowires with a thin InGaP cladding layer, a GaP nucleation segment in the base of the nanowires, and with the Au based seed particle still attached to the top. Such structures were also transferred to neutral substrates for PL characterization. As shown in FIG. 16 the yield is essentially 100 percent on both GaP and Si substrates. The fabrication of the nanostructured LEDs on Si is refined to the degree that the nanowires are uniformly aligned the (111) direction normal to the substrates and essentially no nanowires are grown in the three declined (111) directions that also extends out from the substrate. This in contrast to prior art methods of III-V nanowire growth on Si(111). The well aligned growth of III-V nanowires in predefined array structures on Si substrates, as seen in FIG. 16, is a prerequisite for successful large scale fabrication of optical devices, as well as most other applications.

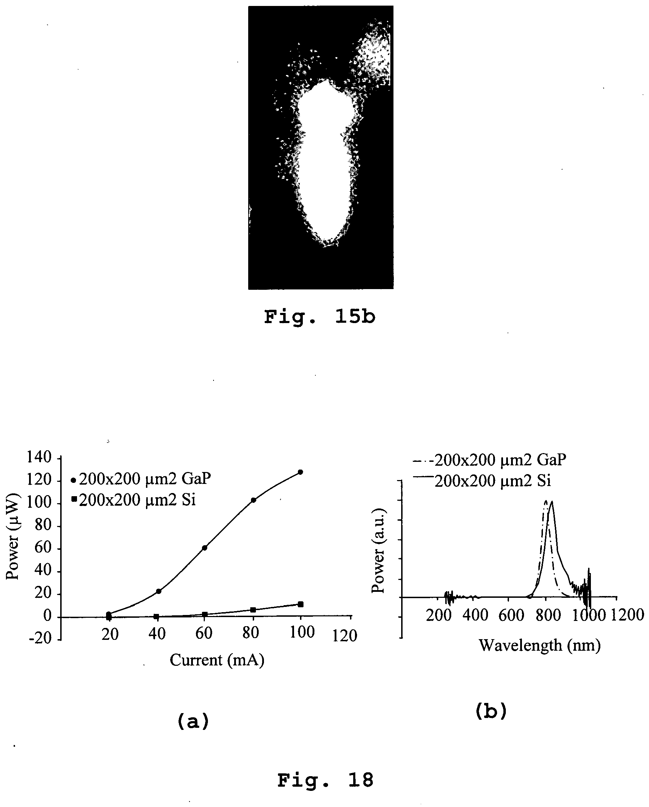

LED functionality can be indicated by Photoluminescence (PL) measurements. The measurements here presented were carried out at room temperature and at a temperature of 10 K. The result is illustrate in the graphs of FIGs. 17a-c and FIG.15b. A laser emitting at 473 nm was used as an excitation source. The PL was collected by an optical microscope, dispersed through a spectrometer and detected by a liquid $N_2$ cooled CCD camera.

To study the PL from the nanowires without influence of the substrate, the nanowires were broken off and transferred from the substrate where they were grown, and then deposited on a patterned Au surface. In this way the nanowires could also be studied individually. The PL spectra, as shown in FIG. 17a, acquired at 10 K from the as-grown nanowires were similar for nanowires grown from a Si substrate and the nanowires grown from a Si substrate (Si) and the nanowires grown from a GaP substrate (GaP). The dashed lines are the spectra from (a large number of) nanowires still standing on the substrate. The spectra from individual nanowires showed larger differences, with the nanowires grown from a GaP substrate being more structured. The average PL intensity for the nanowires grown from Si was about a factor of 20 lower than for the corresponding nanowires grown from GaP. This is in fair agreement with the 10-30 times lower electro-luminence seen for the Si-LED as compared to the GaP-LED. At room temperature the spectra are broad and featureless and there is very little spectral difference between nanowires from the two samples.

Both the LED on GaP and on Si demonstrated electro-luminescence (EL) when applying a forward bias, as shown in FIGs. Ta-b. The spectral peak of the light is in fair agreement with the GaAs bandgap energy.

As seen in Fig. 18a and b the light power/current dependence is shown for the Si based (Si) and GaP based (GaP) LEDs. The LED on GaP lights up at half the current load (20 mA) of the Si (40 mA) and at 60 mA the power output is approximately 30 times higher on the GaP substrate. However, at 100 mA the power ratio has decreased to 10 times the Si based LED. The EL spectral peak is shown for 80 mA load for both devices. The Si LED peak show a slight red shift and tail with a possible extra peak around 1.35 eV as compared to the GaP substrate device. The shift in peaks can be explained by the different In and Ga diffusion on GaP and Si leading to different InGaP composition. By pushing the devices, going to higher currents a peak power can be seen for approximately 140mA for the GaP device. This is not seen with the Si device and may be an indication that nonradiative recombination or competing leakage mechanisms still dominate the EL at these current levels.

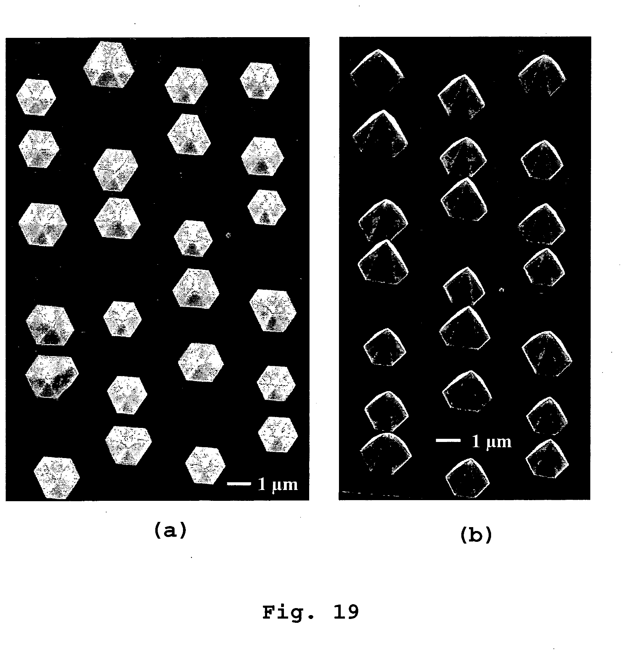

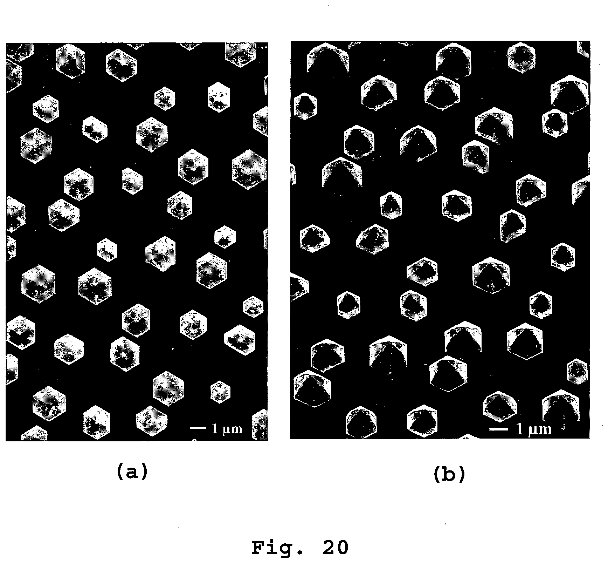

LED devices build on GaN nanowires are of high commercial interest due to their ability to produce light of wavelengths not accessible with other material combinations. As a further implementation example it is described how to grow GaN nanowires by selective area growth on GaN epitaxial films, sapphire, SiC or Si and even self-supporting GaN. On the starting substrate a layer of $SiN_x$ (30 nm in thickness) was deposited by PECVD. In a subsequent step, arrays of dot-patterned GaN openings (around 100 nm in diameter) were made by epitaxial beam lithography, EBL, and reactive ion etching, RIE. The pitch between the openings was ranged as 1.0-3.2 $\mu$m. Then, the as-processed samples were inserted into a, horizontal MOCVD chamber to grow GaN nanowires. The growth process comprises an initial phase wherein, temperature was ramped up to the growth zone of 1000~1500 °C within 5 min with a high $NH_3$ flow rate of 75 sccm for approx. 60 seconds giving an annealing. In a subsequent nanowire growth phase the $NH_3$ flow rate was reduced to 3.0-0.2 sccm to start the growth with introducing TMG (trimethylgallium) into the chamber. Low TMG flow rate was used through this work, between 0.12 and 1.2 $\mu$mol/min. The $NH_3$ flow rate is the crucial factor controlling the growth forms from the openings. FIG. 19 shows the SEM images of the sample grown with the $NH_3$ flow rate of 3.0 sccm. From the top-view image [FIG. 19 (a)], it can be seen that the selective growth from the openings, which is the same as what was reported. The point needed to be specified here is that the lateral size after growth is larger than 1.0 $\mu$m which is much larger than the openings size of around 100 nm. Thus, the lateral growth after GaN had grown out of openings is substantial. FIG. 19 (b) shows the SEM image taken by tilting the sample by 35°, which clearly presents that what were obtained are pyramids, not wires. The pyramids are delimited by six equivalent (1101) planes. The dangling bonds density of (1101) plane is 16.0 /nm², which is higher than that of (1100) plane (12.1 /nm²) and (0001) plane (11.4 /nm²) [3]. From this point of view, the planes of (1100) and (0001) are expected to appear after GaN grows out of the openings. But, FIG. 19 shows the opposite. So, a possible explanation is that (1101) plane has the N-polarization, which makes it stable when $NH_3$ flow rate is high. Based on this, the flow rate of 3 sccm for $NH_3$ is actually still high for growing GaN wires faceted by (1100) plane. FIG. 20 shows the SEM characterizations of the sample grown under $NH_3$ flow rate of 1.0 sccm. The top-view image [FIG. 20 (a)] is similar as FIG. 19 (a). But, the 35°-tilted image [FIG. 20 (b)] is different, that is vertical facets of (1100) plane begin to appear underneath the pyramids caps.

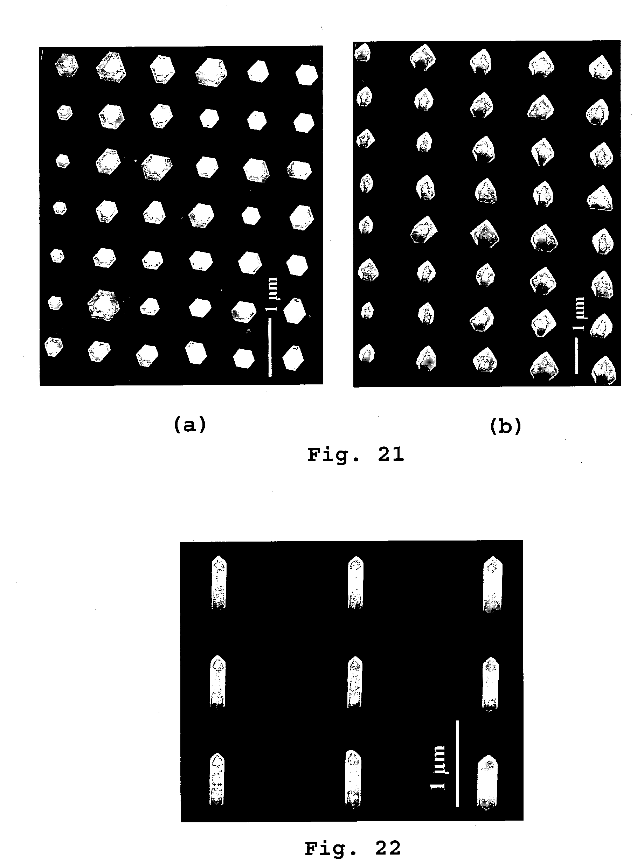

FIG. 21 shows the growth results with reducing $NH_3$ flow rate further to 0.5 sccm. Both top-view and 35°-tilted images indicate the size shrinking in lateral direction, although they are still larger than the openings size of around 100 nm. And the tilted image [FIG. 21 (b)] also shows the vertical facets. As $NH_3$ flow rate was lowered to 0.2 sccm, true GaN nanowires began to be synthesized as shown in FIG. 22. In order to fabricate the GaN nanowires the $NH_3$ flow rate should be adjusted so that a low supersaturation is achived, or alternatively described; to achieve migration enhanced growth. If other shapes are required, for example pyramids, the $NH_3$ flow rate can be 1 sccm or higher. Further fabrication steps, i.e. providing cladding layers and the bulb may be performed in the above described manners.

While the invention has been described in connection with what is presently considered to be the most practical and preferred embodiments, it is to be understood that the invention is not to be limited to the disclosed embodiments, on the contrary, is intended to cover various modifications within the appended claims.

**Claims**

1. A nanostructured LED comprising a substrate (105) and at least one upstanding nanowire (110) protruding from the substrate (105), a pn junction contributing to the formation of an active region (120) to produce light, wherein a waveguide (116) is formed by at least a part of the length of the nanowire (110), said wave guide directing at least a portion of the light produced in the active region in a direction given by the nanowire (110) wherein a portion of the nanowire (110) is enclosed by a volume element (115), the volume element being epitaxially connected to the nanowire (110), said volume element (115) comprising a doping layer (117) which provides the p or n region and a well layer which comprises the active region (120) wherein the volume element provides a high doping level for the formation of the active region (120), wherein the nanowire (110) has a first effective refractive index, $n_w$, and a material (107,112,113,119) surrounding at least a portion of the waveguide (116) has a second effective refractive index, $n_c$, and the first refractive index is larger than the second refractive index, $n_w > n_c$, providing wave-guiding properties to the waveguide (116).

2. The nano structured LED according to claim 1, wherein the waveguide (116) is provided with at least one cladding layer (119) forming a nanowire and cladding assembly in order to enhance the wave-guiding properties of the waveguide (116).

3. The nanostructured LED according to any of claims 1 and 2, wherein the diameter of the waveguide (116) is larger than $\lambda/2n_w$, wherein $\lambda$ is the wavelength of the produced light and $n_w$ is the refractive index of the waveguide (116).

4. The nanostructured LED according to any of claims 1 to 3, wherein the pn junction associated with the active region (120) is formed by combination of the nanowire (110) and the volume element (115).

5. A device comprising a plurality of nanostructured LEDs according to any of the preceding claims, the group of nanostructured LEDs (1100) arranged to emit light in one or a limited set of well-defined directions, and a least one reflecting means (1160) arranged to reflect light from one of the directions associated with the group of nanostructured LEDs (1100).

6. A method of fabricating a nanostructured LED, the nanostructured LED comprising a substrate (105) and at least one upstanding nanowire (110) protruding from the substrate (105), a pn junction contributing to the formation of an active region (120) to produce light, and a waveguide (116) formed along at least a part of the length of the nanowire, the method comprising a first growth of nanowires in a first growth mode promoting nanowire growth and a second selective epitaxial growth of a volume element (115) comprising a doping layer (117) and a well layer (118) in a second growth mode promoting radial growth, such that the volume element (115) encloses a portion of the nanowire and is epitaxially connected to the nanowire wherein the waveguide (116) has a first effective refractive index, $n_w$, and a material (107, 112,113,119) surrounding at least a portion of the waveguide (116) has a second effective refractive index, $n_c$, and the first refractive index is larger than the second refractive index, $n_w > n_c$, providing wave-guiding properties to the waveguide (116).

**Patentansprüche**

1. Nanostrukturierte LED, umfassend ein Substrat (105) und mindestens einen aufrechten Nanodraht (110), der vom Substrat (105) vorsteht, einen p-n-Übergang, der zur Bildung einer aktiven Region (120) zum Erzeugen von Licht beiträgt, wobei ein Wellenleiter (116) durch wenigstens einen Teil der Länge des Nanodrahtes (110) ausgebildet ist, der Wellenleiter wenigstens einen Teil des in der aktiven Region erzeugten Lichts in einer durch den Nanodraht (110) gegebenen Richtung leitet, wobei ein Teil des Nanodrahtes (110) durch ein Volumenelement (115) umschlossen ist, das Volumenelement mit dem Nanodraht (110) epitaxial verbunden ist, das Volumenelement (115) eine Dotierungsschicht (117), welche die p- oder n-Region bereitstellt, und eine Wannenschicht (118) umfasst, welche die aktive Region (120) umfasst, wobei das Volumenelement ein hohes Dotierungsniveau für die Bildung der aktiven Region (120) bereitstellt, wobei der Nanodraht (110) einen ersten effektiven Brechungsindex $n_w$ aufweist, und ein Material (107, 112, 113, 119), das wenigstens einen Teil des Wellenleiters (116) umgibt, einen zweiten effektiven Brechungsindex $n_c$ aufweist, und der erste Brechungsindex größer als der zweite Brechungsindex ist, $n_w > n_c$, wodurch Wellenleiteigenschaften für den Wellenleiter (116) bereitgestellt werden.

2. Nanostrukturierte LED nach Anspruch 1, wobei der Wellenleiter (116) mit mindestens einer Mantelschicht (119) versehen ist, die einen Nanodraht und eine Mantelanordnung bildet, um die Wellenleiteigenschaften des Wellenleiters (116) zu verbessern.

3. Nanostrukturierte LED nach einem der Ansprüche 1 und 2, wobei der Durchmesser des Wellenleiters (116) größer als $\lambda/2n_w$ ist, wobei $\lambda$ die Wellenlänge des erzeugten Lichts ist, und $n_w$ der Brechungsindex des Wellenleiters (116) ist.

4. Nanostrukturierte LED nach einem der Ansprüche 1 bis 3, wobei der p-n-Übergang, der mit der aktiven Region (120) assoziiert ist, durch eine Kombination des Nanodrahtes (110) und des Volumenelements (115) gebildet wird.

5. Vorrichtung, umfassend eine Mehrzahl von nanostrukturierten LEDs nach einem der vorhergehenden Ansprüche, wobei die Gruppe von nanostrukturierten LEDs (1100) zum Emittieren von Licht in einer oder einem begrenzten Satz von klar definierten Richtungen angeordnet ist, und mindestens ein Reflexionsmittel (1160) zum Reflektieren von Licht aus einer der mit der Gruppe von nanostrukturierten LEDs (1100) assoziierten Richtungen angeordnet ist.

6. Verfahren zur Herstellung einer nanostrukturierten LED, wobei die nanostrukturierte LED ein Substrat (105) und mindestens einen aufrechten Nanodraht (110), der vom Substrat (105) vorsteht, einen p-n-Übergang, der zur Bildung einer aktiven Region (120) zum Erzeugen von Licht beiträgt, und einen Wellenleiter (116) umfasst, der wenigstens entlang eines Teils der Länge des Nanodrahtes ausgebildet ist, wobei das Verfahren ein erstes Wachstum von Nanodrähten in einem ersten Wachstumsmodus, der das Nanodrahtwachstum fördert, und ein zweites selektives epitaxiales Wachstum eines Volumenelements (115) mit einer Dotierungsschicht (117) und einer Wannenschicht (118) in einem zweiten Wachstumsmodus umfasst, der radiales Wachstum fördert, derart dass das Volumenelement (115) einen Teil des Nanodrahts umschließt und mit dem Nanodraht epitaxial verbunden ist, wobei der Wellenleiter (116) einen ersten effektiven Brechungsindex $n_w$ aufweist, und ein Material (107, 112, 113, 119), das wenigstens einen Teil des Wellenleiters (116) umgibt, einen zweiten effektiven Brechungsindex $n_c$ aufweist, und der erste Brechungsindex größer als der zweite Brechungsindex ist, $n_w > n_c$, wodurch Wellenleiteigenschaften für den Wellenleiter (116) bereitgestellt werden.

**Revendications**

1. DEL nanostructurée comportant un substrat (105) et au moins un nanofil (110) dressé dépassant du substrat (105), une jonction p-n contribuant à la formation d'une région active (120) pour produire de la lumière, un guide (116) d'ondes étant formé par au moins une partie de la longueur du nanofil (110), ledit guide d'ondes dirigeant au moins une partie de la lumière produite dans la région active dans une direction donnée par le nanofil (110), une partie du nanofil (110) étant enveloppée par un élément (115) de volume, l'élément de volume étant relié de manière épitaxiale au nanofil (110), ledit élément (115) de volume comportant une couche (117) de dopage qui met en place la région p ou n et une couche de puits (118) qui comporte la région active (120), l'élément de volume assurant un niveau de dopage élevé pour la formation de la région active (120), le nanofil (110) présentant un premier indice effectif de réfraction, $n_w$, et un matériau (107, 112, 113, 119) entourant au moins une partie du guide (116) d'ondes présentant un deuxième indice effectif de réfraction, $n_c$, et le premier indice de réfraction étant supérieur au deuxième indice de réfraction, $n_w > n_c$, ce qui confère des propriétés de guidage d'ondes au guide (116) d'ondes.

2. DEL nanostructurée selon la revendication 1, le guide (116) d'ondes étant muni d'au moins une couche (119) de gaine formant un ensemble nanofil-gaine afin de renforcer les propriétés de guidage d'ondes du guide (116) d'ondes.

3. DEL nanostructurée selon l'une quelconque des revendications 1 et 2, le diamètre du guide (116) d'ondes étant supérieur à $\lambda/2n_w$, où $\lambda$ est la longueur d'onde de la lumière produite et $n_w$ est l'indice de réfraction du guide (116) d'ondes.

4. DEL nanostructurée selon l'une quelconque des revendications 1 à 3, la jonction p-n associée à la région active (120) étant formée par la combinaison du nanofil (110) et de l'élément (115) de volume.

5. Dispositif comportant une pluralité de DEL nanostructurées selon l'une quelconque des revendications précédentes, le groupe de DEL nanostructurées (1100) étant agencé pour émettre une lumière dans une direction ou un ensemble limité de directions bien définies, et au moins un moyen (1160) de réflexion agencé pour réfléchir une lumière provenant d'une des directions associées au groupe de DEL nanostructurées (1100).

6. Procédé de fabrication d'une DEL nanostructurée, la DEL nanostructurée comportant un substrat (105) et au moins un nanofil (110) dressé dépassant du substrat (105), une jonction p-n contribuant à la formation d'une région active (120) pour produire de la lumière, et un guide (116) d'ondes formé sur au moins une partie de la longueur du nanofil, le procédé comportant une première croissance de nanofils dans un premier mode de croissance favorisant la croissance de nanofils et une deuxième croissance épitaxiale sélective d'un élément (115) de volume comportant une couche (117) de dopage et une couche de puits (118) dans un deuxième mode de croissance favorisant la croissance radiale, de telle façon que l'élément (115) de volume enveloppe une partie du nanofil et soit relié de manière épitaxiale au nanofil, le guide (116) d'ondes présentant un premier indice effectif de réfraction, $n_w$, et un matériau (107, 112, 113, 119) entourant au moins une partie du guide (116) d'ondes présentant un deuxième indice effectif de réfraction, $n_c$, et le premier indice de réfraction étant supérieur au deuxième indice de réfraction, $n_w > n_c$, ce qui confère des propriétés de guidage d'ondes au guide (116) d'ondes.

**Fig. 1a**

**Fig. 1b**

**Fig. 2**

100

115

110

108

116

105

## Fig. 3a

100

115

108    110

112
113    107

116

105

## Fig. 3b

**Fig. 4**

**Fig. 5**

**Fig. 6**

**Fig. 7**

**Fig. 8**

**Fig. 9**

**Fig. 10**

**Fig. 11**

Fig. 12

Fig. 13

Fig. 14

Fig. 15a

Fig. 16

Fig. 17

Fig. 15b

(a)

(b)

Fig. 18

(a)

(b)

Fig. 19

(a)                              (b)

Fig. 20

(a)                                        (b)

Fig. 21

Fig. 22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1369935 A
- US 20040075464 A, Samuelson
- US 20030168964 A
- US 2006280414 A
- US 2005224790 A
- US 2003010244 A

### Non-patent literature cited in the description

- **HARAGUCHI et al.** GaAs p-n junction formed in quantum crystals. *Appl. Phys. Lett.,* 1992, vol. 60 (6
- **QUIAN et al.** Core/ Multishell Nanowire Heterostructure as Multicolor, High-Efficiency Light-Emitting Diodes. *Nanoletters*